# EUROPEAN PATENT SPECIFICATION

(11) **EP 3 004 417 B1**
(45) Date of publication and mention of the grant of the patent: **31.01.2018**
(21) Application number: 14731834.9
(22) Date of filing: 30.05.2014
(51) Int. Cl.: C23C 16/455

(54) **INJECTOR HEAD FOR ATOMIC LAYER DEPOSITION**
INJEKTORKOPF FÜR ATOMLAGENABSCHEIDUNG
TÊTE D'INJECTEUR POUR DÉPÔT DE COUCHE ATOMIQUE

(30) Priority: 30.05.2013 NL 2010893
(43) Date of publication of application: 13.04.2016
(73) Proprietor: Solaytec B.V., 5652 AM Eindhoven (NL)
(72) Inventor: VERMEER, Adrianus Johannes Petrus Maria, NL-5652 AM Eindhoven (NL); VAN DIJK, Ronald Henrica Maria, NL-5652 AM Eindhoven (NL)
(74) Representative: V.O.
(86) International application number: PCT/NL2014/050346
(87) International publication number: WO 2014/193234

(56) References cited:
- WO-A1-2012/028780
- US-A1- 2011 023 775

## Description

### FIELD OF THE INVENTION

The invention relates to an injector head for atomic layer deposition on a surface of a substrate. The invention further relates to an apparatus comprising such an injector head.

### BACKGROUND

Atomic layer deposition is known as a method for (repeated) depositing of a monolayer of target material. Atomic layer deposition differs from for example chemical vapour deposition in that atomic layer deposition takes at least two process steps. Atomic layer deposition has the advantage of enabling a good layer thickness control.

A first one of these process steps comprises application of a precursor gas on the substrate surface. To this end, known injector heads are provided with a deposition space having a precursor supply. The supply is arranged for providing a precursor gas flow from the precursor supply via the deposition space to a precursor drain. In this way a deposition space is formed that in use is bounded by the injector head and the substrate surface.

A second one of these process steps comprises reaction of the precursor material in order to form the monolayer of target material. To this end a further deposition space is provided in the injector head having a reactant supply. The further deposition space is in use separated from precursor gas by a flow barrier and can be arranged for providing at least one of a reactant gas, a plasma, laser-generated radiation, and ultraviolet radiation for reacting the precursor after deposition of the precursor gas on at least part of the substrate surface.

In order to provide for the flow barrier, barrier gas flow may be injected between the injector head and the substrate surface. The known injection head further comprises a connection unit connectable to a respective plurality of gas supply sources and drain collectors thus providing access for respective gases via said connection unit, to a respective precursor deposition space, reactant deposition space and flow barrier.

WO 2012/105831 of the same inventor herein incorporated by reference describes an atomic layer deposition apparatus and a specific injector head arrangement. For such arrangements manufacturability is a challenge in view of the relatively high friction factor that is needed in order to provide a homogenous gas flow of the various process gases. This homogeneity is important in order to carry out a robust atomic layer deposition process. At the same time it is also important that the design is compact, since a larger number of injector heads can significantly enhance the throughput of the system.

WO2008/085474 discloses an apparatus for deposition of atom layers. A deposition head is provided by a stack of platelets, which, in view of the large number of platelets and the complicated flow paths can be problematic. A challenge exist to provide an injector head that is manufacturable and provides for the necessary homogeneity of the flow of process gasses.

US 2011/023775 A1 discloses an ALD injector head made up of stacked bars with spacers forming gas supply paths and drains with selected gas friction factors (impedances). The exhausts have a low friction factor and the precursor supplies have a high friction factor.

WO 2012/028780 A1 discloses an ALD injector head including bars with slots distanced by spacers.

### SUMMARY

Accordingly, it is an object, according to an aspect of the invention, to provide an apparatus and method for atomic layer deposition with improved homogeneity of the process gases, wherein a reliable and stable slit width is provided and a compact design can be provided.
Accordingly, an injector head is provided for atomic layer deposition on a substrate, comprising a plurality of monolithic bars coupled to a connection unit. The bars have side walls with a spacer profile, respectively stacked against side walls of a neighbouring bar to form a plurality of stacked bars.
The bars comprise slots extending over a length of the bar in communication with a respective slot in the manifold. A flow path is defined through the bar with a relatively low friction factor to form a respective precursor drain; reactant drain or barrier gas drain. The spacer profiles define slits extending between adjacent bars in communication with a respective slot in the manifold. A further flow path is formed along the bar with a relatively high friction factor, to form a respective precursor gas supply; reactant gas supply or flow barrier. By the slotted bar design, at the same time accurately formed slits can be formed while ensuring mechanical integrity by the monolithic bar design. This significantly enhances manufacturability and facilitates compliance to design specification.

### BRIEF DESCRIPTION OF THE DRAWINGS

The invention will now be described, in a non-limiting way, with reference to the accompanying drawings, in which:
Figure 1 shows a schematic side view of an embodiment according to the invention
Figure 2 shows a schematic plan view of another embodiment
Figure 3 shows an embodiment of an injector head according to another embodiment of the invention;
Figure 4 shows a schematic arrangement of a setup for an apparatus for atomic layer deposition according to another embodiment.
Figure 5 illustrates a construction detail of two slotted bars in semi-assembled state;
Figure 6 shows a detail of an embodiment of a slotted bar design;
Figure 7 shows a further planar view of a profiled side wall of the slotted bar.
Figure 8 shows another schematic example of slot design in the injector head.
Figure 9 shows a schematic example of an undulate shape.

Unless stated otherwise, the same reference numbers refer to like components throughout the drawings.

### DETAILED DESCRIPTION

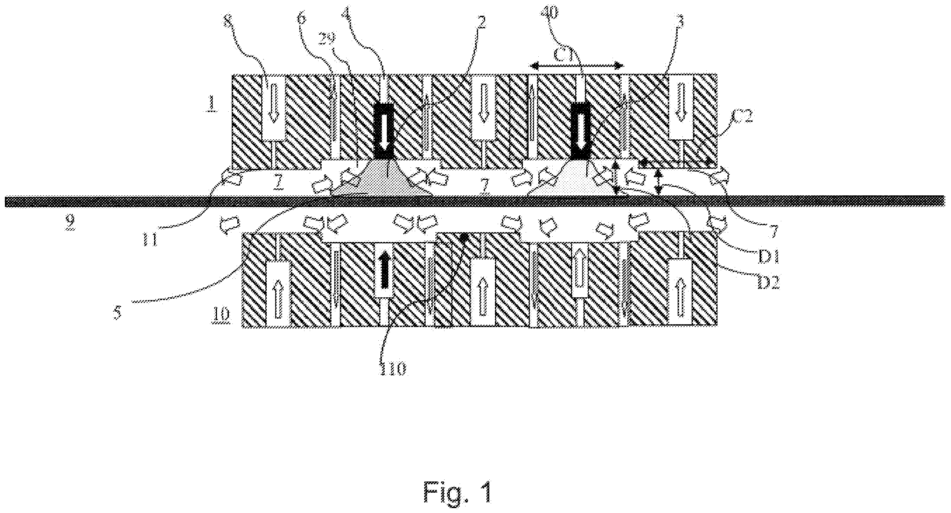

Figure 1 shows a schematic side view of an embodiment according to the invention. As an example, an injector head 1 is shown having two deposition spaces 2, 3 separated by a gas bearing region. While for atomic layer in principle, at least two process steps are needed, only one of the process steps may need involvement of material deposition. Such material deposition may be carried out in a deposition space 2 provided with a precursor supply 4. Accordingly, in this embodiment it is shown that injector head comprises a further deposition space 3 provided with a reactant supply 40, the further deposition space 3 in use being bounded by the gas bearing 7. Alternatively or additionally, at least one of a reactant gas, a plasma, laser-generated radiation, and ultraviolet radiation, may be provided in the reaction space for reacting the precursor with the reactant gas after deposition of the precursor gas on at least part of the substrate surface in order to obtain the atomic layer on the at least part of the substrate surface. By suitable purging of spaces 2, and 3, the supplies 4 and 40 may be switched during processing. This can be done precisely timed in a manner that the precursor gas only flows into the deposition space while the wafer is present at the position of the deposition space. This will prevent costly precursor gas flowing to the exhaust without use, while the wafer is outside the deposition space, thus further enhancing the precursor gas use efficiency.

The precursor and reactant supplies 4, 40 are preferably designed without substantial flow restrictions to allow for plasma deposition. Thus, towards a substrate surface 5, plasma flow is unhindered by any flow restrictions.

In this embodiment, a precursor gas is circulated in the deposition space 2 by a flow alongside the substrate surface 5. The gas flow is provided from the precursor supply 4 via the deposition space to the precursor drain 6. In use the deposition space 2 is bounded by the injector head 1 and the substrate surface 5. Gas bearings 7 are provided with a bearing gas injector 8 arranged adjacent the deposition space, for injecting a bearing gas between the injector head 1 and the substrate surface 5, the bearing gas thus forming a gas-bearing while confining the injected precursor gas to the deposition space 2. The precursor drain 6 may additionally function to drain bearing gas preventing flow of bearing gas into the deposition space 2, 3.

While in the embodiment each gas bearing 7 is shown to be dimensioned as a gas bearing, in principle, this is not necessary; for example, a flow barrier separating the deposition spaces 2, 3 need not be dimensioned as a gas bearing as long as an effective flow barrier is provided. Typically, a flow barrier may have a gap height that is larger than a gap height wherein a gas bearing is effective. In practical examples, the gas bearing operates in gap height ranges from 5 um - 100 um; wherein a flow barrier may still be effective above such values, for example, until 500 um. Also, gas bearings 7 may only be effective as flow barrier (or gas bearing for that matter) in the presence of substrate 9; while flow barriers may or may not be designed to be active irrespective of the presence of substrate 9. Importantly, flow of active materials between deposition spaces 2, 3 is prevented by flow barriers at any time to avoid contamination. These flow barriers may or may not be designed as gas bearings 7.

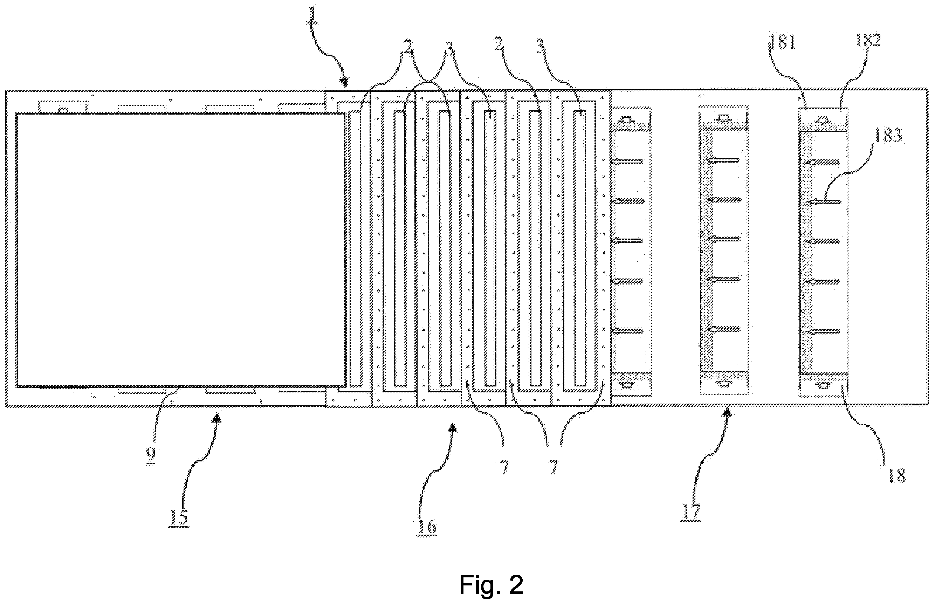

While Figure 1 not specifically shows a conveying system (see more detail in Figure 2), the substrate 9 can be moved relative to the injector head 2, to receive subsequent deposition of materials from deposition spaces 2 and 3. By reciprocating motion of the substrate 9 relative to the injector head 1, the number of layers can be controlled. However, the present disclosure is not limited to this embodiment, the injector head design as further disclosed herebelow may also be provided in atomic layer deposition machines that have a reciprocating head relative to a substrate that is fixed on a support table; the substrate provided on a reciprocating support table etc. Also non-reciprocating embodiments may be feasible.

A support part 10 may provided that provides a carrier less support for substrate 9 along a conveying plane which may be seen as the centre line of substrate 9. The support part 10 is arranged opposite the injector head and is constructed to provide a gas bearing pressure arrangement that balances the injector head gas-bearing 7 in the conveying plane. Although less then perfect symmetrical arrangements may be feasible to provide the effect, preferably, the balancing is provided by having an identical flow arrangement in the support part as is provided by the injector head 1. Thus, preferably, each flow ejecting nozzle of the support part 10 is symmetrically positioned towards a corresponding nozzle of the injector head 1. In this way, the substrate can be held supportless, that is, without a mechanical support, by said gas bearing pressure arrangement in between the injector head 1 and the support part 10. More in general, a variation in position, along the conveying plane, of flow arrangements in the injector head 1 and in the support part 10, that is smaller than 0.5 mm, in particular smaller than 0.2 mm, may still be regarded as an identical flow arrangement. In the example, by absence of any mechanical support, a risk of contamination of such support is prevented which is very effective in securing optimal working height of the injector head 1 relative to the substrate 9. In addition, less down time of the system is necessary for cleaning purposes. Furthermore, importantly, by absence of a mechanical support, a heat capacity of the system can be reduced, resulting in faster heating response of substrates to production temperatures, which may significantly increase production throughput and reduce power consumption.

In this respect, the deposition space defines a deposition space height D2 relative to a substrate surface; and wherein the gas bearing 7, functioning as flow barrier, comprises a flow restricting surface 11 facing a substrate surface 5, defining, relative to a substrate, a gap distance D1 which is smaller than the deposition space height D2. The deposition space is provided with a precursor supply 4 and a precursor drain 6. Said supply and drain may be arranged for providing a precursor gas flow from the precursor supply via the deposition space to the precursor drain. In use, the deposition space is bounded by the injector head 1 and the substrate surface. The deposition space may be formed by a cavity 29, having a depth D2-D1, in which the supply and drain end and/or begin. Thus, more in general, the cavity is defined in the deposition head 1 and is, in use, facing the substrate 9. By having the cavity 29 facing the substrate, it is understood that the substrate is substantially forming a closure for the cavity, so that a closed environment is formed for supplying the precursor gas. In addition, the substrate may be provided such that various adjacent parts of the substrate or even adjacent substrates or other parts may be forming such closure. The apparatus may be arranged for draining the precursor gas by means of the precursor drain 6 of the deposition head 1 from the cavity for substantially preventing precursor gas to escape from the cavity. It may be clear that the bearing supply may be positioned at a distance from the cavity. The cavity may enable to apply process conditions in the cavity that are different from process conditions in the gas-bearing layer. Preferably, the precursor supply 4 and/or the precursor drain 6 are positioned in the cavity.

The depth D2-D1 of the cavity 29 may be defined as a local increase in distance between the substrate 9 and an output face of the injector head provided with the bearing gas injector 8 and the precursor supply. The depth D2 minus D1 may be in a range from 10 to 500 micrometers, more preferably in a range from 10 to 100 micrometers.

The flow restricting surface 11 may be formed by projecting portions 110 including bearing gas injector 8. The gas-bearing layer in use is for example formed between the surface 5 and the flow restricting surface 11. A distance C1 between the precursor drains 30 may typically be in a range from 1 to 10 millimeter, which is also a typical width of the deposition space 2, 3. A typical thickness of the gas-bearing layer, indicated by D1, may be in a range from 3 to 15 micrometer. To accommodate for various surface flatness qualities, however, the bearing gap may larger than 15 micrometer, for example, extended to larger dimensions, for example, up to 70 micrometer. A typical width C2 of the projecting portion 110 may be in a range from 1 to 30 millimeter. A typical thickness D2 of the deposition space 2 out of the plane of the substrate 9 may be in a range from 3 to 300 micrometer.

This enables more efficient process settings. As a result, for example, a volumetric precursor flow rate injected from the supply 4 into the deposition space 2 can be higher than a volumetric flow rate of the bearing gas in the gas-bearing layer, while a pressure needed for the injecting of the precursor gas can be smaller than a pressure needed for injecting the bearing gas in the gas-bearing layer. It will thus be appreciated that the thickness *D₁* of the gas-bearing layer 7 may in general be less than a thickness *D₂* of the deposition space 2, measured in a plane out of the substrate surface.

At a typical flow rate of 5 ·10⁻⁴ - 2 ·10⁻³ m³/s per meter channel width and a typical distance of *L* = 5 mm, e.g. being equal to a distance from the precursor supply to the precursor drain, the channel thickness *D_{c},* e.g. the thickness *D₂* of the deposition space 2, should preferably be larger than 25 - 40 µm. However, the gas-bearing functionality preferably requires much smaller distances from the precursor injector head to the substrate, typically of the order of 5 µm, in order to meet the important demands with respect to stiffness and gas separation and in order to minimize the amount of bearing gas required. The thickness *D₂* in the deposition space 2 being 5 µm however, with the above-mentioned process conditions, may lead to unacceptably high pressure drops of ∼ 20 bar. Thus, a design of the apparatus with different thicknesses for the gas-bearing layer (i.e. the thickness *D₁*) and deposition space (i.e. the thickness *D₂*) is preferably required. For flat substrates, e.g. wafers - or wafers containing large amounts of low aspect ratio (i.e. shallow) trenches 8 having an aspect ratio A (trench depth divided by trench width) ≤ 10 - the process speed depends on the precursor flow rate (in kg/s): the higher the precursor flow rate, the shorter the saturation time.

For wafers containing large amounts of high aspect ratio (i.e. deep narrow) trenches of A ≥ 50, the process speed may depend on the precursor flow rate and on the precursor partial pressure. In both cases, the process speed may be substantially independent of the total pressure in the deposition space 2. Although the process speed may be (almost) independent of total pressure in the deposition space 2, a total pressure in the deposition space 2 close to atmospheric pressure may be beneficial for several reasons:
∘ At sub-atmospheric pressures, the gas velocity v_{g} in the deposition space 2 is desired to increase, resulting in an undesirably high pressure drop along the deposition space 2.
∘ At lower pressures, the increase in the gas velocity v_{g} leads to a shorter gas residence time in the deposition space 2, which has a negative effect on yield.
∘ At lower pressures, suppression of precursor leakage from the deposition space 2 through the gas-bearing layer may be less effective.
∘ At lower pressures, expensive vacuum pumps may be required.

The lower limit of the gas velocity v_{g} in the deposition space 2 may be determined by the substrate traverse speed vₛ: in general, in order to prevent asymmetrical flow behaviour in the deposition space 2, the following condition should preferably be satisfied: This condition provides a preferred upper limit of the thickness D, D₂ of the reaction space 3. By meeting at least one, and preferably all, of the requirements mentioned above, an ALD deposition system is obtained for fast continuous ALD on flat wafers and for wafers containing large amounts of high aspect ratio trenches.

Accordingly, in use, the total gas pressure in the deposition space 2 may be different from a total gas pressure in the additional deposition space 3. The total gas pressure in the deposition space 2 and/or the total gas pressure in the additional deposition space 3 may be in a range from 0.2 to 3 bar, for example 0.5 bar or 2 bar or even as low as 10 mBar , in particular, in a range of 0.01 bar to 3 bar. Such pressure values may be chosen based on properties of the precursor, for example a volatility of the precursor. In addition, the apparatus may be arranged for balancing the bearing gas pressure and the total gas pressure in the deposition space, in order to minimize flow of precursor gas out of the deposition space.

Figure 2 shows a schematic plan view of an injector head 1 depicted in plan view. The injector head 1 comprises alternating slits of deposition spaces 2, 3, for precursors and reactants respectively, each bounded by gas bearings/flow barriers 7. The substrate is seen to be carried into working zone 16 where injector head 1 is active, from a lead in zone 15. The working zone 16 is adjacent the lead in zone 15 and is aligned relative to the conveying plane, so that the substrate can be easily conveyed between these zones 15, 16. An additional lead out zone 17 may be provided. Depending on process steps, lead in and lead out can be interchanged or alternated. Thus, a substrate 9 can be moved reciprocatingly along a center line between the two zones 15, 17 through working zone 16.

In the shown embodiment the conveying system is provided with pairs of gas inlets 181 and outlets 182 facing the conveying plane and providing a flow 183 along the conveying plane from the outlet 182 towards the inlet 181. For clarity reasons only one pair is referenced in the figure. A gas flow control system is arranged to provide a gas bearing pressure and a gas flow 183 along the conveying plane, to provide movement of the substrate 9 along the conveying plane along a center line through the working zone 16 by controlling the gas flow.

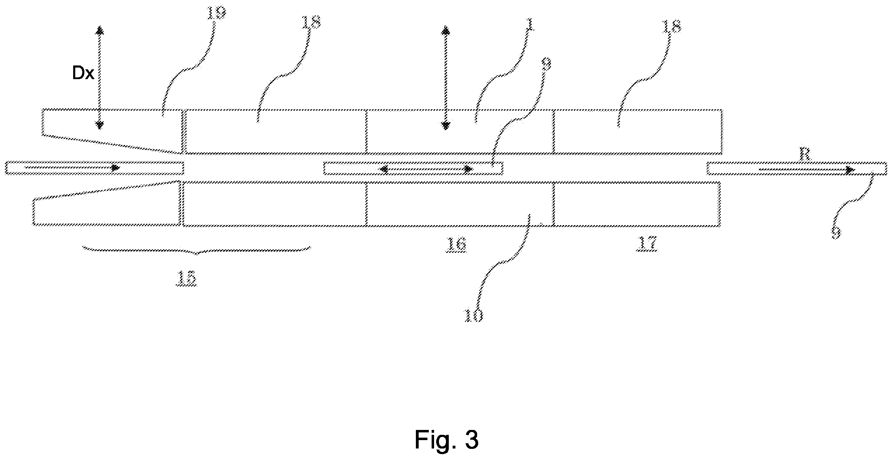

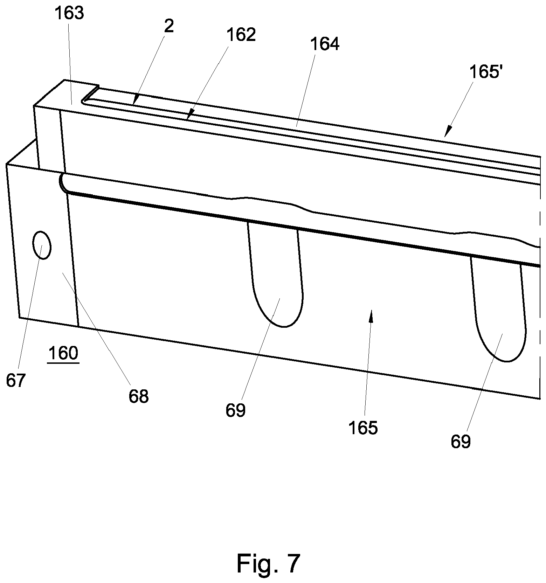

Figure 3 shows a schematic side view of a further embodiment. Reference is made to the previous figures. In particular, a lead in zone 15 is shown, a working zone 16 and a lead out zone 17. The working zone is formed by injector head 1 and support 10. In the lead in and lead out zone, transport elements or drive sections 18 are provided for providing a transport of the substrate 9 along a conveying plane, indicated by direction R. According to an embodiment, the lead in zone 15 comprises slanted wall parts 19 facing the conveying plane. The drive section 18 comprises transport elements (see Fig 7A) arranged to provide relative movement of the substrate and the injector head along a plane of the substrate to form a conveying plane along which the substrate is conveyed. The lead in zone 15 comprises slanted wall parts symmetrically arranged relative to the conveying plane coinciding with substrate 9. The slanted wall parts 19 are formed and constructed to reduce a working height Dx from about 100 - 200 micron above the substrate 9 in a first conveying direction P towards the drive section 18 to a reduced working height of ranging from 30 - 100 micron, preferably about 50 micron, forming the smallest gap distance.

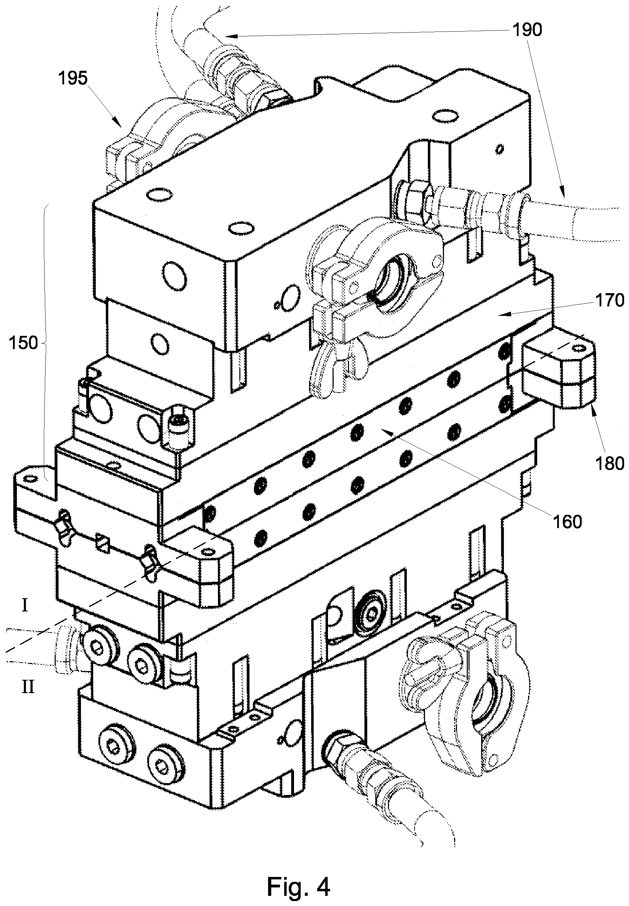

Figure 4 shows a schematic arrangement of a setup for an apparatus for atomic layer deposition according to another embodiment. For illustration purposes, similarly as the above examples, the disclosed embodiment is geared towards carrier less actuation and has a substantially symmetrical arrangement in the regions I, II. The bar design as further exemplified below may be applied in other arrangements, e.g. a one sided injector head designed solely in region I. In particular, the components identified in region I are not indicated in region II. In region I, the injector head design is formed by a connection unit 150 connectable to a respective plurality of gas supply sources 190 and drain collectors 195 thus providing access for respective gases via said connection unit 150, to a respective precursor deposition space, reactant deposition space and flow barrier in the injector head (see below). The connection unit may be of suitable common design, but preferably is provided in modular block arrangement that can be bolted together. It may comprise a manifold block 170, that provides a flow path to a a plurality of monolithic bars 160 coupled to the connection unit 150. The bars may be coupled in a convenient sealing way to the manifold block 170, preferably by shoulder pieces 180 that clamp the bars in a form closing manner to the manifold 170. The manifold may be manufactured as a single integral piece e.g. by milling, drilling.

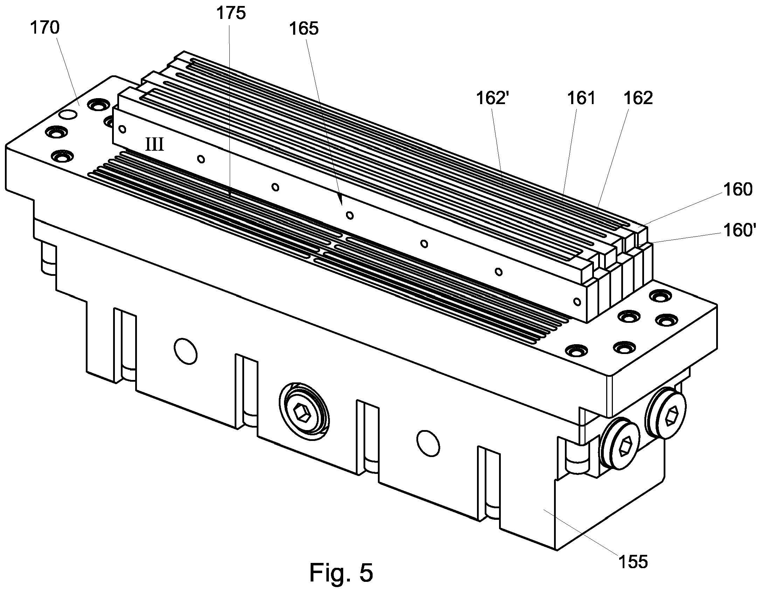

To better understand the construction of Figure 4, Figure 5 illustrates a construction detail of the slotted bars 160, 160' in semi-assembled state. The bars 160 have side walls 165 with a spacer profile (further details herebelow), respectively stacked against a neighbouring bar 160' to form a plurality of stacked bars. The spacer profile defines a narrow slit 161 extending between adjacent bars in communication with a respective slot in the manifold 170. In completed state, the entire manifold is populated with correspondingly stacked bars 160 (illustrated with III) forming slits 161 and having slots 162 each connected to a respective slot 175 in the manifold 170. Further, the manifold is coupled to a distribution block 155, that distributes the process gasses to the connection unit 150.

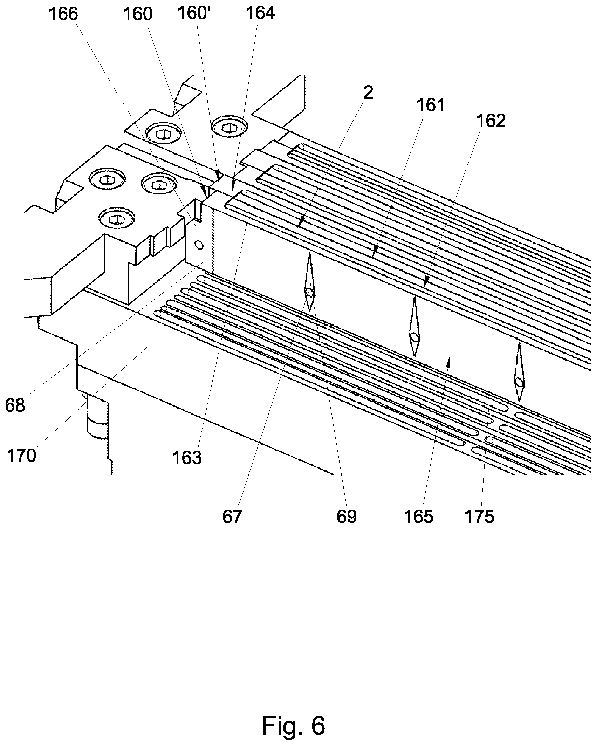

The slits 161 thus defining a flow path along the bar 160 with a relatively high friction factor, to form a respective precursor gas supply; reactant gas supply or flow barrier. A typical slit width may be 40-200micron, more particularly 50-125 micron. This provides a significant pressure drop in the supplies depositing the reaction gases and/or barrier gases near the substrate surface, providing excellent homogeneity in gas distribution, flow barrier and/or gas bearing functionality. Figure 6 shows a detail of an embodiment of a slotted bar design. In the shown embodiment, bars 160 comprise a slot 162 extending over a length of the bar 160 in communication with a respective slot 175 in the manifold, thus defining a flow path through the bar 160 with a relatively low friction factor, to form a respective precursor drain; reactant drain or barrier gas drain. A slit 161 is surrounded by two slots 162, 162' of a respective neighbouring bar 160.

Stack assembly may be provided by shoulders 166 coupling to previously described shoulder pieces; and by pulling rods provided in through holes 67. These may be provided in selected elevations 69, or in side elevations 68 surrounding the through hole 67. These elevations may have polygon shape, in particular with a symmetry axis in the direction of flow. Other assembly techniques may be provided such as gluing, welding clamping etc.

It is one of the inventive insights, that the exhaust channels do not need a high friction factor, and therefore may be machined with relatively wide slot dimensions. Accordingly, a slot may have a slot width of 200-1000 micrometer. It is another inventive insight that the exhaust slots may be drilled with a channel width that may increase (to accommodate drilling equipment) in the direction from the deposition face 164, as long as the slot width is properly dimensioned near the exhaust 162 in the deposition space 2.

Accordingly, large elongated holes 162 are made in the centre of elongated bars 160. The centrally arranged relatively large machined slots do not deteriorate the stiffness of the bars 160, allowing accurate machining of the bars for precise definition of the slits 161.

It is noted that the friction factor F is inversely proportional to a slit channel length l, slit length L, and a cube of slit gap width d, according to the equality F∼1/l*L*d^3. Since the side wall can be accurately dimensioned over the entire height of the bar 160, forming the length of the slit channel the flow homogeneity can be increased considerably. By selectively designed orifice areas in a sealing foil (not shown) that may be provided between the manifold block 170 and the slotted bars 160, a flow profile may be adjusted for the exhaust slots 162 and supply slits 161, in order to further balance a flow profile between the various channels.

While many slotted designs may be provided, preferably, the facing side 164 of the bars 160 has a contour 163 profiled to form deposition spaces 2. While Figure 6 only schematically illustrates the bars 160 and corresponding supply slit 161 and exhaust slots 162, Figure 7 illustrates in more detail a bar 160 showing a exhaust slot 162 extending over a length of the bar 160. Contour 163 extends along a side wall 165 thus defining a recessed portion 2 having a deposition space height relative to the substrate surface when in use.

Opposite walls 165, 165' of the bar 160 may have a similar profiled design, wherein the lower wall side 165' ends in the recessed part 2 forming a supply slit in a deposition space for process gas injection. The spacer profile may in this way define a slit width of 10-250 micrometer.

Opposite to the lower wall 165' the higher wall side 165 ends in contour 163. The contour 163 has a face side defining, relative to the substrate, gap distance smaller than the deposition space height to form the barrier gas injector, in the example formed by barrier gas injected along side wall 165. The spacer profiles on the profiled wall 165 are formed by interspaced elevations 69 provided on a planar bottom wall.

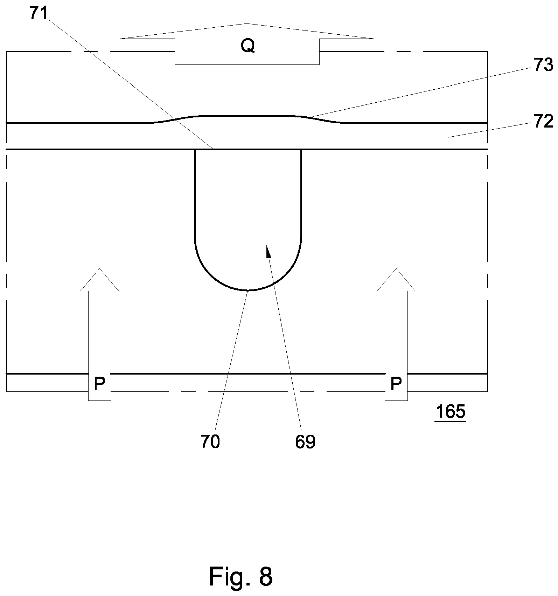

Figure 8 shows a view of a detail of the profiled side wall 165 of the slotted bar having an optimized design. Outflowing gas flow Q may be homogenized over the entire length of the slit by a spacer design 69. To this end, elevation 69 may have a dome shape 70 facing the direction of flow P. In addition, the elevation may have a flattened side 71 opposing the dome shape.

To further optimize the flow profile a distribution groove 72 may be provided below the elevations 69 seen in the direction of flow P. The groove may extend along a length of the side wall, substantially parallel to the face side, i.e. in a crossing direction relative to the flow P. The groove 72 may be provided adjacent the elevations 69 and may have a depth optimized to the flow, for example, about 150-200 micron and may be strip shaped to provide flow distribution over the elongation of the slit.

Preferably the groove has a widening part 73 adjacent the elevation further optimizing the flow profile. The groove may define a groove width of 1000-2500 micron and wherein the widening may be 100-500 micron.

Many profiled designs may provide for a gas flow with increased friction factor, in particular, a patterned profiling of microburls, semi-porous channel design, or interspaced elevations having polygon shape, in particular with a symmetry axis in the direction of flow. Depending on the design, the spacers themselves may introduce inhomogeneity in the gas flow through the slit. Preferably, the elevations 69 have a flow guide contour arranged to homogenize a gas flow below the interspaced elevations seen in the direction of flow.

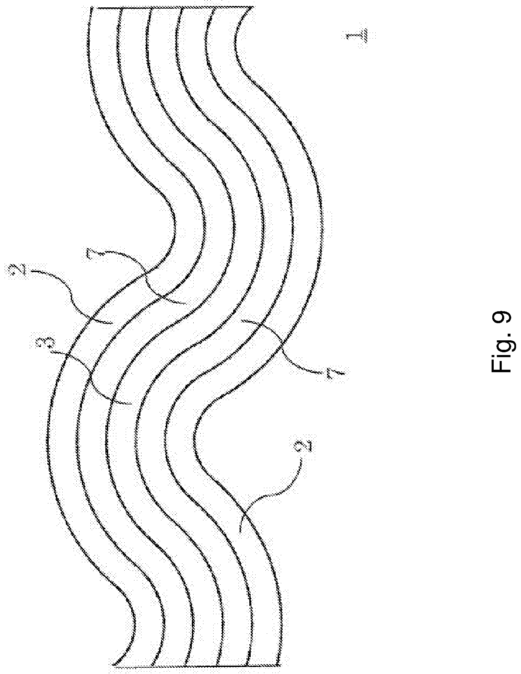

Figure 9 shows a schematic example of an undulate shape for the injector head 1 seen in a direction normal to the substrate surface, to illustrate the scope of application of the slotted bars in the present disclosure. Throughout, the terms "slot" and "slit" denote elongated orifices in the injector head having differing widths respectively. Such orifices provide for process gas throughput through the injector head in order to carry out the atomic deposition layer process steps. A slit typically has a smaller width than a slot as further explained above. Furthermore, the term bar is commonly used to denote a stackable elongated integral shape having sufficient thickness to house a slot extending through the bar along its face while providing mechanical integrity, which slot can be formed by machining precision techniques such as drilling. The bar may be planar, e.g. rectangular in shape but may not be limited to these shapes. For optimal flow guidance the slots and slits have inner surfaces substantially equidistantly arranged relative to each other. While the slits are formed by form following contour of the bars, the slots are manufactured by machining, e.g. drilling through the bar. The slots may also follow the planarity of the bar. Alternatively, a curved shape of the slots may prevent first order bending modes of the substrate. Accordingly, it can be seen that the gas bearing 7 is formed, seen in a direction normal to the substrate surface, as undulated shapes to prevent first order bending modes of the sheet substrate. In addition, typically, the shape of deposition spaces, slits 2, 3 may follow the shape of the gas bearing slits 7 to allow for compact injector head construction. In the figures, the surrounding exhaust slots are not depicted. These variations allow for optimization of a pressure distribution on the substrate surface. Such optimization can be important for fragile or flexible substrates.

Equally all kinematic inversions are considered inherently disclosed and to be within the scope of the present invention. The use of expressions like: "preferably", "in particular", "typically", etc. is not intended to limit the invention. The indefinite article "a" or "an" does not exclude a plurality. For example, an apparatus in an embodiment according to the invention may be provided with a plurality of the injector heads. It may further be clear that the terms 'relative motion' and 'relative movement' are used interchangeably. Aspects of disclosed embodiment may be suitably combined with other embodiments and are deemed disclosed. Features which are not specifically or explicitly described or claimed may be additionally included in the structure according to the present invention without deviating from its scope.

## Claims

1. Injector head for atomic layer deposition on a substrate, comprising:
- a deposition space (2) provided with a precursor supply (4) and a precursor drain (6); said supply and drain arranged for providing a precursor gas flow from the precursor supply via the deposition space to the precursor drain; the deposition space in use being bounded by the injector head and the substrate surface;
- a flow barrier (7) arranged for injecting a barrier gas flow between the injector head and the substrate surface; and
- a further deposition space (3) provided with a reactant supply (40), the further deposition space in use being bounded from precursor gas by the flow barrier (7), and arranged for providing at least one of a reactant gas, a plasma, laser-generated radiation, and ultraviolet radiation for reacting the precursor after deposition of the precursor gas on at least part of the substrate surface;
- a connection unit (150) connectable to a respective plurality of gas supply sources and drain collectors thus providing access for respective gases via said connection unit, to a respective precursor deposition space, reactant deposition space and flow barrier; wherein
- a plurality of bars (160) is coupled to the connection unit, the bars having side walls (165) with a spacer profile (69), respectively stacked against side walls of a neighbouring bar to form a plurality of stacked bars; the bars comprising slots extending over a length of the bar in communication with a respective slot in the connection unit, thus defining a flow path through the bar with a relatively low friction factor, to form a respective precursor drain; reactant drain or barrier gas drain;
- said spacer profiles (69) defining slits (161) extending between adjacent bars in communication with a respective slot (162) in the connection unit, thus defining a further flow path along the bar with a relatively high friction factor, to form a respective precursor gas supply; reactant gas supply or flow barrier.

2. Injector head according to claim 1, wherein the spacer profiles are formed by interspaced elevations.

3. Injector head according to claim 1, wherein the elevations have a flow guide contour arranged to homogenize a gas flow below the interspaced elevations seen in the direction of flow.

4. Injector head according to claim 3, further comprising a distribution groove provided below the elevations seen in the direction of flow extending along a length of the side wall.

5. Injector head according to claim 4, wherein the groove is strip shaped and is provided adjacent the elevations.

6. Injector head according to claim 4 - 5, wherein the groove has a widening part adjacent the elevation.

7. Injector head according to claim 6, wherein the groove defines a groove width of 1000-2500 micron and wherein the widening is 100-500 micron.

8. Injector head for atomic layer deposition according to any of the preceding claims, wherein the spacer profile defines a slit width of 10-250 micrometer.

9. Injector head for atomic layer deposition according to any of the preceding claims, wherein the slot has a slot width of 200-1000 micrometer.

10. Injector head for atomic layer deposition according to any of the preceding claims, wherein the bars each have a contour extending along a side wall defining a deposition space height D2 relative to the substrate surface; and wherein the contour has a face side defining, relative to the substrate, a gap distance D1 smaller than the deposition space height D2 to form the barrier gas injector.

11. Apparatus for atomic layer deposition comprising an injector head according to claims 1-10.

12. Apparatus for atomic layer deposition according to claim 11, further comprising a support part arranged opposite the injector head, the support part constructed to provide a gas bearing pressure arrangement that counters the flow barrier pressure, so that the substrate is balanced supportless by said gas bearing pressure arrangement in between the injector head and the support part.

13. Apparatus for atomic layer deposition on a surface of a sheeted substrate according to claim 11, further comprising a conveying system comprising a drive section (18); the drive section comprising transport elements arranged to provide relative movement of the substrate and the injector head along a plane of the substrate to form a conveying plane along which the substrate is conveyed towards the injector head in a conveying direction.

## Patentansprüche

1. Injektorkopf zur Atomlagenabscheidung auf einem Substrat, umfassend:
- einen Abscheidungsraum (2), versehen mit einem Vorläuferzulauf (4) und Vorläuferabfluss (6) welcher Zulauf und Abfluss angeordnet sind, um einen Vorläufergasstrom von dem Vorläuferzulauf über den Abscheidungsraum zu dem Vorläuferabfluss bereitzustellen, welcher Abscheidungsraum bei Verwendung von dem Injektorkopf und der Substratoberfläche begrenzt wird;
- eine Fließbarriere (7), angeordnet zum Injizieren eines Barrieregasstroms zwischen dem Injektorkopf und der Substratoberfläche; und
- einen weiteren Abscheidungsraum (3), versehen mit einer Reaktantzufuhr (40), welcher weitere Abscheidungsraum bei Verwendung vom Vorläufergas durch die Fließbarriere (7) begrenzt wird, und angeordnet, um mindestens eines von einem Reaktantgas, einem Plasma, einer lasererzeugten Strahlung und einer Ultraviolettstrahlung bereitzustellen, um den Vorläufer nach dem Abscheiden des Vorläufergases auf mindestens einem Teil der Substratoberfläche zu reagieren;
- eine Verbindungseinheit (150), zu verbinden mit einer entsprechenden Vielzahl von Gaszufuhrquellen und Abflusskollektoren, um so einen Zugang für entsprechende Gase über die Verbindungseinheit zu einem entsprechenden Vorläuferabscheidungsraum, Reaktantabscheidungsraum und einer Fließbarriere bereitzustellen, wobei
- eine Vielzahl von Stangen (160) an die Verbindungseinheit gekoppelt ist, welche Stangen Seitenwände (165) mit einem Abstandsprofil (69) haben, jeweils gestapelt gegen Seitenwände einer benachbarten Stange, um eine Vielzahl gestapelter Stangen zu bilden, welche Stangen Spalte umfassen, die über eine Länge der Stange in Kommunikation mit einem entsprechenden Schlitz in der Verbindungseinheit verlaufen, um so einen Fließweg durch die Stange mit einem relativ niedrigen Reibungsfaktor zu definieren, um einen entsprechenden Vorläuferabfluss, Reaktantabfluss oder Barrierengasabfluss zu bilden;
- die Abstandsprofile (69) Schlitze (161) definieren, die zwischen angrenzenden Stangen in Kommunikation mit einem entsprechenden Spalt (162) in der Verbindungseinheit verlaufen, um so einen weiteren Fließweg entlang der Stange mit einem relativ hohen Reibungsfaktor zu definieren, um eine entsprechende Vorläufergaszufuhr, Reaktantgaszufuhr oder Fließbarriere zu bilden.

2. Injektorkopf nach Anspruch 1, wobei die Abstandsprofile von beabstandeten Erhebungen gebildet werden.

3. Injektorkopf nach Anspruch 1, wobei die Erhebungen eine Stromführungskontur haben, angeordnet zum Homogenisieren eines Gasstroms zwischen den beabstandeten Erhebungen, gesehen in Fließrichtung.

4. Injektorkopf nach Anspruch 3, ferner umfassend eine Verteilungsrille, bereitgestellt unter den Erhebungen, gesehen in Fließrichtung, verlaufend entlang einer Länge der Seitenwand.

5. Injektorkopf nach Anspruch 4, wobei die Rille streifenförmig ist und neben den Erhebungen bereitgestellt ist.

6. Injektorkopf nach Anspruch 4-5, wobei die Rille einen geweiteten Teil neben der Erhebung hat.

7. Injektorkopf nach Anspruch 6, wobei die Rille eine Rillenbreite von 1000-2500 Mikron definiert und wobei die Weitung 100-500 Mikron beträgt.

8. Injektorkopf zur Atomlagenabscheidung nach einem der vorhergehenden Ansprüche, wobei das Abstandsprofil eine Schlitzbreite von 10-250 Mikrometer definiert.

9. Injektorkopf zur Atomlagenabscheidung nach einem der vorhergehenden Ansprüche, wobei der Spalt eine Spaltbreite von 200-1000 Mikrometer hat.

10. Injektorkopf zur Atomlagenabscheidung nach einem der vorhergehenden Ansprüche, wobei die Stangen jeweils eine Kontur haben, die entlang einer Seitenwand verläuft, definierend eine Abscheidungsraumhöhe D2 in Bezug auf die Substratoberfläche; und wobei die Kontur eine Vorderseite hat, die zu dem Substrat einen Lückenabstand D1 definiert, die kleiner ist als die Abscheidungsraumhöhe D2, um den Barrieregasinjektor zu bilden.

11. Vorrichtung zur Atomlagenabscheidung, umfassend einen Injektorkopf nach den Ansprüchen 1-10.

12. Vorrichtung zur Atomlagenabscheidung nach Anspruch 11, ferner umfassend ein Trägerteil, angeordnet gegenüber dem Injektorkopf, welches Trägerteil konstruiert ist, um eine Gaslagerdruckanordnung bereitzustellen, die dem Fließbarrierendruck entgegenwirkt, sodass das Substrat trägerlos von der Gaslagerdruckanordnung zwischen dem Injektorkopf und dem Trägerteil balanciert wird.

13. Vorrichtung zur Atomlagenabscheidung auf einer Oberfläche eines ausgewalzten Substrats nach Anspruch 11, ferner umfassend ein Fördersystem, umfassend einen Antriebsabschnitt (18); welcher Antriebsabschnitt Transportelemente umfasst, angeordnet zum Bereitstellen einer relativen Bewegung des Substrats und des Injektorkopfes entlang einer Ebene des Substrats, um eine Förderebene zu bilden, an der entlang das Substrat zu dem Injektorkopf in einer Förderrichtung befördert wird.

## Revendications

1. Tête d'injecteur pour le dépôt de couche atomique sur un substrat comprenant :
un espace de dépôt (2) prévu avec une alimentation en précurseur (4) et un drain de précurseur (6) ; ladite alimentation et ledit drain étant agencés pour fournir un écoulement de gaz précurseur de l'alimentation en précurseur via l'espace de dépôt au drain de précurseur ; l'espace de dépôt étant délimité, à l'usage, par la tête d'injecteur et la surface de substrat ;
une barrière d'écoulement (7) agencée pour injecter un écoulement de gaz barrière entre la tête d'injecteur et la surface de substrat ; et
un espace de dépôt supplémentaire (3) prévu avec une alimentation en réactif (40), l'espace de dépôt supplémentaire étant délimité, à l'usage, par rapport au gaz précurseur, par la barrière d'écoulement (7), et agencé pour fournir au moins l'un parmi un gaz réactif, un plasma, un rayonnement généré par laser, et un rayonnement ultraviolet pour faire réagir le précurseur après le dépôt du gaz précurseur sur au moins une partie de la surface de substrat ;
une unité de raccordement (150) pouvant être raccordée à une pluralité respective de sources d'alimentation en gaz et de collecteurs de drain, fournissant ainsi l'accès, pour des gaz respectifs via ladite unité de raccordement, à un espace de dépôt de précurseur respectif, un espace de dépôt de réactif et une barrière d'écoulement ; dans laquelle :
une pluralité de barres (160) est couplée à l'unité de raccordement, les barres ayant des parois latérales (165) avec un profilé de dispositif d'espacement (69), respectivement empilées contre des parois latérales d'une barre voisine afin de former une pluralité de barres empilées ; les barres comprenant des fentes s'étendant sur une longueur de la barre en communication avec une fente respective dans l'unité de raccordement, définissant ainsi une trajectoire d'écoulement à travers la barre avec un facteur de friction relativement faible, pour former un drain de précurseur respectif ; un drain de réactif ou un drain de gaz barrière ;
lesdits profilés de dispositif d'espacement (69) définissant des fentes (161) s'étendant entre des barres adjacentes en communication avec une fente (162) respective dans l'unité de raccordement, définissant ainsi une autre trajectoire d'écoulement le long de la barre avec un facteur de friction relativement élevé, pour former une alimentation en gaz précurseur respective ; une alimentation en gaz réactif ou une barrière d'écoulement.

2. Tête d'injecteur selon la revendication 1, dans laquelle les profilés de dispositif d'espacement sont formés par des élévations espacées.

3. Tête d'injecteur selon la revendication 1, dans laquelle les élévations ont un contour de guide d'écoulement agencé pour homogénéiser un écoulement de gaz au-dessous des élévations espacées observées dans la direction d'écoulement.

4. Tête d'injecteur selon la revendication 3, comprenant en outre une rainure de distribution prévue au-dessous des élévations observées dans la direction d'écoulement s'étendant le long d'une longueur de la paroi latérale.

5. Tête d'injecteur selon la revendication 4, dans laquelle la rainure est en forme de bande et est prévue de manière adjacente aux élévations.

6. Tête d'injecteur selon les revendications 4 à 5, dans laquelle la rainure a une partie d'élargissement adjacente à l'élévation.

7. Tête d'injecteur selon la revendication 6, dans laquelle la rainure définit une largeur de rainure de 1 000 à 2 500 microns et dans laquelle l'élargissement est de 100 à 500 microns.

8. Tête d'injecteur pour le dépôt de couche atomique selon l'une quelconque des revendications précédentes, dans laquelle le profilé de dispositif d'espacement définit une largeur de fente de 10 à 250 micromètres.

9. Tête d'injecteur pour le dépôt de couche atomique selon l'une quelconque des revendications précédentes, dans laquelle la fente a une largeur de fente de 200 à 1 000 micromètres.

10. Tête d'injecteur pour le dépôt de couche atomique selon l'une quelconque des revendications précédentes, dans laquelle les barres ont chacune un contour s'étendant le long d'une paroi latérale définissant une hauteur d'espace de dépôt D2 par rapport à la surface de substrat ; et dans laquelle le contour a un côté de face définissant, par rapport au substrat, une distance d'espace D1 inférieure à la hauteur d'espace de dépôt D2 pour former l'injecteur de gaz barrière.

11. Appareil pour le dépôt de couche atomique comprenant une tête d'injecteur selon les revendications 1 à 10.

12. Appareil pour le dépôt de couche atomique selon la revendication 11, comprenant en outre une partie de support agencée à l'opposé de la tête d'injecteur, la partie de support étant construite pour fournir un agencement de pression de palier à gaz qui s'oppose à la pression de barrière d'écoulement, de sorte que le substrat est équilibré sans support par ledit agencement de pression de palier à gaz entre la tête d'injecteur et la partie de support.

13. Appareil pour le dépôt de couche atomique sur une surface d'un substrat en feuille selon la revendication 11,
comprenant en outre un système de transport comprenant une section d'entraînement (18) ; la section d'entraînement comprenant des éléments de transport agencés pour fournir le déplacement relatif du substrat et de la tête d'injecteur le long d'un plan du substrat pour former un plan de transport le long duquel le substrat est transporté vers la tête d'injecteur dans une direction de transport.
